(19) Europäisches Patentamt / European Patent Office / Office européen des brevets

(11) **EP 4 391 734 A1**

(12) **EUROPEAN PATENT APPLICATION**

(43) Date of publication:
26.06.2024 Bulletin 2024/26

(21) Application number: 23193485.2

(22) Date of filing: 25.08.2023

(51) International Patent Classification (IPC):
*H05K 1/03* (2006.01)    *H05K 3/02* (2006.01)
*B32B 15/08* (2006.01)    *H05K 1/09* (2006.01)
*B21B 1/40* (2006.01)

(52) Cooperative Patent Classification (CPC):
**H05K 1/0393; H05K 1/09; H05K 3/022;**
**H05K 3/384;** B32B 15/08

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: 21.12.2022 JP 2022204740
22.12.2022 JP 2022205900

(71) Applicant: **JX Metals Corporation**
**Tokyo 105-8417 (JP)**

(72) Inventors:
• **ISHINO, Yuji**
**Hitachi-shi, 3170056 (JP)**
• **IKEDA, Takao**
**Kouza-gun, 253-0101 (JP)**

(74) Representative: **Mewburn Ellis LLP**
**Aurora Building**
**Counterslip**
**Bristol BS1 6BX (GB)**

(54) **COPPER FOIL, LAMINATE, AND FLEXIBLE PRINTED WIRING BOARD**

(57) A copper foil, wherein at least one surface of the copper foil has a developed interfacial area ratio (sdr) of 0.0030 or less.

Processed by Luminess, 75001 PARIS (FR)

Description

FIELD OF THE INVENTION

The present invention relates to a copper foil, a laminate, and a flexible printed wiring board. In particular, the present invention relates to a copper foil having excellent electrical conductivity as a copper foil for high-frequency circuits, and a laminate and a flexible printed wiring board provided with such a copper foil.

BACKGROUND OF THE INVENTION

Printed wiring boards have made great progress over the last half century, and are now used in almost all electronic devices. In recent years, with the increasing needs for miniaturization and high performance of electronic devices, high-density mounting of mounted parts and signals with higher frequency are progressing, and there is a demand for printed wiring boards that can cope with high frequencies.

High-frequency circuit boards are required to reduce transmission loss in order to ensure the quality of output signals. Transmission loss mainly consists of dielectric loss caused by the resin (substrate side) and conductor loss caused by the conductor (copper foil side). Dielectric loss decreases as the dielectric constant and dielectric loss tangent of the resin decrease. In high-frequency signals, the main cause of conductor loss is that the cross-sectional area through which current flows decreases due to the skin effect, that is, the higher the frequency is, the more current flows only on the surface of the conductor, and the resistance increases.

As a technique for reducing the transmission loss of a copper foil for high frequency circuits, for example, Patent Literature 1 (Japanese Patent No. 4161304) discloses a metal foil for high frequency circuits, in which one or both surfaces of the metal foil surface is coated with silver or a silver alloy, and a coating layer other than the silver or the silver alloy is coated on the silver or the silver alloy coating layer to a thickness thinner than the thickness of the silver or the silver alloy coating layer. Further, according to this literature, it is possible to provide a metal foil that reduces loss due to the skin effect even in the ultra-high frequency range used in satellite communications.

In addition, Patent Literature 2 (Japanese Patent No. 4704025) discloses a roughening treated rolled copper foil for high frequency circuits characterized in that, a ratio of an integrated intensity ($I_{(200)}$) of a (200) plane determined by X-ray diffraction on the rolled surface after recrystallization annealing of the rolled copper foil to an Integrated intensity ($I_{0(200)}$) of a (200) plane determined by X-ray diffraction of fine copper powder is $I_{(200)} / I_{0(200)} > 40$, and an arithmetic mean roughness (hereinafter referred to as Ra) of a roughened surface after a roughening treatment by electrolytic plating on the rolled surface is 0.02 $\mu$m to 0.2 $\mu$m, and a ten-point average roughness (hereinafter referred to as Rz ) is 0.1 $\mu$m to 1.5 $\mu$m, and it is a material for printed circuit boards. Further, according to this literature, it is possible to provide a printed circuit board that can be used at high frequencies exceeding 1 GHz.

In addition, Patent Literature 3 (Japanese Patent Application Publication No. 2004-244656) discloses an electrolytic copper foil, characterized in that part of the surface of the copper foil is an uneven surface with a surface roughness of 2 $\mu$m to 4 $\mu$m consisting of hump-like protrusions. Further, according to this literature, it is described that an electrolytic copper foil excellent in high frequency transmission characteristics can be provided.

Furthermore, Patent Literature 4 (Japanese Patent Application Publication No. 2017-193778) discloses a copper foil having a roughened layer, wherein the roughened layer has a primary particle layer, a surface roughness Ra of the primary particle layer side surface is 0.12 $\mu$m or less, and an average particle size of the primary particles of the primary particle layer is 0.10 to 0.25 $\mu$m. It is described that, by forming such a predetermined roughened particle layer and controlling the surface roughness Ra of the roughened particle layer side surface and the average particle diameter of the roughened particles, it is effective in suppressing transmission loss when used in high-frequency circuit boards.

PRIOR ART

Patent Literature

[Patent Literature 1] Japanese Patent No. 4161304

[Patent Literature 2] Japanese Patent No. 4704025

[Patent Literature 3] Japanese Patent Application Publication No. 2004-244656

[Patent Literature 4] Japanese Patent Application Publication No. 2017-193778

## SUMMARY OF THE INVENTION

In recent years, with the further progress of higher frequency signals, there is a growing need for manufacturing printed wiring boards with superior transmission characteristics in a high frequency range such as 60 GHz or higher, and further improvement of copper foil, which is the raw material, is required. In particular, the higher the frequency of the signal is, the lower the conductivity of the copper foil becomes due to the skin effect, which becomes a factor in worsening the transmission loss. However, with the techniques described in Patent Literatures 1 to 4, it can be difficult to cope with high-frequency circuit boards of 60 GHz or higher. In particular, the invention according to Patent Literatures 4 focuses on the fact that the roughness of the copper foil surface is the main factor of conductor loss, and that the smaller the roughness is, the lower the transmission loss is. The are excellent inventions in that both suppression of transmission loss and adhesion to a resin can be achieved by controlling the surface roughness Ra of the roughened particle layer side surface and the average particle size of the roughened particles. However, there is also the problem that the conditions for roughening treatment must be strictly controlled. In addition, the presence of roughening particles inevitably increases the resistance due to the skin effect as described above.

The present invention has been completed in view of the above problems, and in one embodiment, an object of the present invention is to provide a copper foil having excellent electrical conductivity as a copper foil for high frequency circuits. Further, in another embodiment, another object of the present invention is to provide the laminate provided with such a copper foil.

As a result of intensive studies, the inventors of the present invention found that it is effective to adjust the developed interfacial area ratio (sdr) as a characteristic of a copper foil for suppressing the above-mentioned skin effect and suppressing the decrease in conductivity in high-frequency transmission. The present invention has been completed based on the above findings, and is exemplified as below.

[1] A copper foil, wherein at least one surface of the copper foil has a developed interfacial area ratio (sdr) of 0.0030 or less.

[2] The copper foil according to [1], wherein the at least one surface of the copper foil has the developed interfacial area ratio (sdr) of 0.0025 or less.

[3] The copper foil according to [1] or [2], further comprising a surface treatment layer on the at least one surface.

[4] The copper foil according to any one of [1] to [3], wherein the copper foil is a rolled copper foil.

[5] A laminate, comprising the copper foil according to any one of [1] to [4]; and a resin substrate.

[6] A flexible printed wiring board provided with the laminate according to [5].

According to one embodiment of the present invention, it is possible to provide a copper foil having excellent electrical conductivity as a copper foil for high frequency circuits. Furthermore, according to another embodiment of the present invention, it is possible to provide a laminate provided with such a copper foil.

## BRIEF DESCRIPTION OF THE DRAWINGS

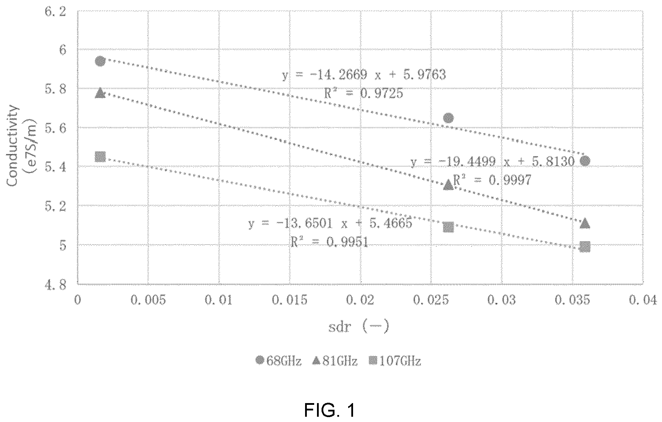

FIG. 1 is a graph plotting sdr on the horizontal axis and conductivity on the vertical axis based on Examples and Comparative Examples.

## DETAILED DESCRIPTION OF THE INVENTION

Hereinafter, embodiments of the present invention will now be described in detail. It should be understood that the present invention is not intended to be limited to the following embodiments, and any change, improvement or the like of the design may be appropriately added based on ordinary knowledge of those skilled in the art without departing from the spirit of the present invention.

(Composition of copper foil)

There is no particular limitation on the form of the copper foil that can be used in this embodiment. In addition, typically, the copper foil used in the present invention may be either an electrolytic copper foil or a rolled copper foil. In general, an electrolytic copper foil is manufactured by electrolytically depositing copper from a copper sulfate plating bath onto a titanium or stainless steel drum, and a rolled copper foil is manufactured by repeating plastic working and heat treatment using rolling rolls. Rolled copper foil is often used for applications that require flexibility.

As the copper foil material, in addition to high-purity copper such as tough pitch copper and oxygen-free copper, which are usually used as conductor patterns of printed wiring boards, for example, copper containing Sn, copper containing Ag, copper alloys such as copper alloys with added P, Cr, Zr, Mg, and the like, and Corson copper alloys with added Ni, Si, and the like can also be used. In this specification, when the term "copper foil" is used alone, it also includes copper alloy foil.

In addition, the thickness of the copper foil is not particularly limited, but for example, it may be 1 to 1000 $\mu$m, or 1 to 500 $\mu$m, or 1 to 300 $\mu$m, or 3 to 100 $\mu$m, or 5 to 70 $\mu$m, or 6 to 35 $\mu$m, or 9 to 18 $\mu$m.

The copper foil of this embodiment can be suitably used for high frequency circuit applications. Here, the high-frequency circuit means a circuit in which the signal frequency transmitted through the circuit is 60 GHz or higher.

In the present embodiment, at least one surface of the copper foil has a developed interfacial area ratio (sdr) of 0.0030 or less. The developed interfacial area ratio is an index showing how much the developed area of a defined region increases with respect to the area of the defined region, and the sdr of a completely flat surface without irregularities is 0. If the surface has irregularities and the surface area (developed area) is larger than that of a flat surface, sdr becomes larger than zero. As the sdr increases, the conductivity at high frequencies decreases due to the aforementioned skin effect, so it is preferably small. From this point of view, the developed interfacial area ratio (sdr) is preferably 0.0028 or less, more preferably 0.0025 or less, and even more preferably 0.0020 or less. The lower limit of sdr is not limited from the viewpoint of electrical conductivity, but it is assumed there are some cases where scratches on the copper foil surface become conspicuous, so it is desirable to be 0.0001 or more, more preferably 0.0002 or more.

As more typical indicators of surface roughness, arithmetic mean height (Sa) and maximum height (Sz) can be mentioned, but it is considered that they are not suitable for representing the degree of increase in transmission distance when a signal flows only near the surface of the copper foil due to the skin effect. This is because it is considered that the maximum height (Sz) is an index whose value fluctuates greatly due to particular points such as scratches scattered on the copper foil surface, and it is inappropriate as an indicator of characteristics as a high-frequency circuit when signals flows over the entire copper foil surface. Further, the arithmetic mean height (Sa) is considered inappropriate because there is concern that fine undulations that contribute to an increase in transmission distance may be ignored due to larger undulations. Therefore, it is considered that the developed interfacial area ratio (sdr), which directly represents the degree of increase in transmission distance when a signal flows only near the surface of the copper foil due to the skin effect, is a suitable index that represents the essential properties.

As described later, the developed interfacial area ratio (sdr) is calculated upon a measurement of the roughness data of a copper foil surface with a Keyence laser microscope VK-X1000 (controller unit) / 1050 (head unit) or an equivalent device, in accordance with ISO25178-2:2012.

Moreover, at least one surface of the copper foil can be provided with a surface treatment layer. The surface treatment layer may be a roughening treatment layer. Roughening treatment is usually performed on the surface of the copper foil to be adhered to a resin substrate, that is, the surface on the surface treatment layer side, for the purpose of improving the peel strength of the copper foil after lamination. This refers to a process of forming bumpy electrodeposits on the surface of copper foil after degreasing. Although an electrolytic copper foil has unevenness at the time of production, the unevenness can be further enhanced by strengthening the convex portions of the electrolytic copper foil by roughening treatment. The roughening treatment can be performed, for example, by forming roughening particles with copper or a copper alloy. The roughening treatment may be performed for fine particles. The roughened layer may be a layer consisting of any one selected from the group consisting of copper, nickel, cobalt, phosphorus, tungsten, arsenic, molybdenum, chromium and zinc, and the like, or a layer consisting of an alloying containing one or more selected from the above group. Moreover, after forming roughening particles with copper or a copper alloy, it is also possible to carry out a further roughening treatment in which secondary particles or tertiary particles are provided with nickel, cobalt, copper, zinc as a single substance or an alloy, or the like. Moreover, one or more layers selected from the group consisting of a heat-resistant layer, an antirust layer, a chromate-treated layer and a silane-coupling-treated layer may be formed on the surface of the roughening treatment layer.

Further, the surface treatment layer may be one or more layers selected from the group consisting of a heat-resistant layer, an antirust layer, a chromate treatment layer and a silane coupling treatment layer, in addition to the roughening treatment layer. These layers can be provided using a known technique. In addition, as described later, the copper foil of the present invention can be controlled for the above-mentioned developed interfacial area ratio (sdr) without any surface treatment, so in one embodiment, the copper foil does not comprise a surface treatment layer in the sense that the manufacturing method can be simple.

A laminate can be produced by bonding the copper foil of the present invention to a resin substrate. The resin substrate is not particularly limited as long as it has properties applicable to printed wiring boards or the like. However, for example, a polyester film such as polyethylene terephthalate (PET), a polyimide film, a liquid crystal polymer (LCP) film, a fluororesin film, or the like can be used.

The method of lamination can be laminating and adhering a rolled copper foil to a substrate such as a polyimide film via an adhesive or under high temperature and high pressure without using an adhesive, or by coating, drying, curing, and the like of a polyimide precursor to manufacture a laminate.

Also, the laminate can be used to construct a printed wiring board, particularly a flexible printed wiring board. Therefore, in another aspect, the present invention discloses a method for manufacture a printed wiring board, particularly a flexible printed wiring board, using the rolled copper foil of the present invention and the laminate of the present invention.

(Manufacture method)

The method for manufacturing the copper foil of the present invention is not particularly limited as long as the above-mentioned developed interfacial area ratio (sdr) can be controlled within the scope of the present invention. However, as a manufacture method that can be easily carried out without surface treatment, a method of appropriately adjusting the oil film thickness equivalent of a final rolling pass in a final cold rolling step can be adopted.

In the present embodiment, as a method for manufacturing the rolled copper foil, first, raw materials are melted in a melting furnace to obtain molten metal having a desired composition. Then, this molten metal is cast into an ingot. Thereafter, hot rolling, cold rolling, and annealing are performed as appropriate to finish a foil having a predetermined thickness. After the heat treatment, the surface may be pickled, polished, or the like in order to remove the surface oxide film generated during the heat treatment. In the final cold rolling, the material after the heat treatment is repeatedly passed through a rolling mill to finish it to a predetermined thickness. In the method for manufacturing a rolled copper foil of the present embodiment, it is important to perform the final rolling pass with an oil film thickness equivalent of 10,000 to 40,000 in the final rolling pass of the final cold rolling step.

By controlling the oil film thickness equivalent, the developed interfacial area ratio of the copper foil surface can be suppressed. If the oil film thickness equivalent exceeds 40,000, the effect of flattening the surface of the copper foil becomes weak, and the reduction in the developed interfacial area ratio becomes insufficient. On the other hand, if the oil film thickness equivalent is less than 10,000, the oil film between the copper foil and the rolling rolls becomes thin, so scratches and dirt on the surface of the rolling rolls are easily transferred to the copper foil surface, and the developed interfacial area ratio may increase.

Here, the oil film thickness equivalent is defined by the following formula.

$$\text{Oil film thickness equivalent} = \frac{(\text{rolling oil viscosity [cSt]}) \times (\text{entry side passing speed [mm/s]} + \text{roll peripheral speed [mm/s]})}{(\text{roll bite angle [rad]}) \times (\text{rolling load per unit area [kg/mm}^2\text{]})}$$

Rolling oil viscosity was measured according to JIS K2283. The entry side passing speed is calculated from the peripheral speed of the take-up reel on the exit side in consideration of the rolling work degree of the rolling pass. The roll peripheral speed is calculated from the peripheral speed of the take-up reel on the exit side, assuming that no slip occurred between the rolls and the material. Further, the roll bite angle and the rolling load per unit area are calculated using the following formulas. In addition, for the Young's modulus and Poisson's ratio of the roll, the values described in the roll manufacturer's catalog and the literature values of the roll material are used, respectively. The radius of the rolls is obtained by measuring the diameter with a roll diameter measuring machine capable of measuring in units of 0.0005 mm. The rolling load is calculated using the diameter and number of cylinders from the pressure measured by the hydraulic sensors of the hydraulic cylinders of the rolling mill. The reduction amount was calculated from the thickness of the material before and after passing. The material strip thickness can be measured, for example, according to the method for measuring mass thickness of JIS C6515.

$$\text{Roll bite angle} = \left\{ \frac{(\text{reduction amount [mm]})}{(\text{flat radius of roll [mm]})} \right\}^{0.5}$$

$$\text{Rolling load per unit area} = (\text{rolling load [kg]}) / \{(\text{average strip width [mm]}) \times (\text{contact arc length [mm]})\}$$

$$\text{Flat radius of roll} = (\text{radius of roll [mm]}) \times [1 + 16 \times \{1 - (\text{Poisson's ratio of roll})^2\} / \{\pi \times (\text{Young's modulus of roll [kg/mm}^2])\} \times (\text{rolling load [kg]}) / \{(\text{average strip width [mm]}) \times (\text{reduction amount [mm]})\}]$$

$$\text{Contact arc length} = \{(\text{reduction amount [mm]}) \times (\text{flat radius of roll [mm]})\}^{0.5}$$

In addition, the numerical value of the oil film thickness equivalent in Table 1 is a numerical value rounded to the nearest 100.

In order to control the oil film thickness equivalent, known methods such as using low-viscosity rolling oil or slowing the entry side passing speed may be used.

**EXAMPLES**

Hereinafter, the present invention will be described in greater detail by way of Examples, but the descriptions here are for illustrative purposes only and are not intended to be limiting.

First, a copper ingot having the copper ratio shown in Table 1 was prepared and hot rolled. After performing hot rolling, cold rolling and annealing in an annealing furnace set at a temperature of 300 to 800 °C were performed for once or more, and then cold rolling was performed to obtain a rolled strip having a thickness of 0.1 to 1.0 mm. The rolled strip was annealed in an annealing furnace set at a temperature of 300 to 800 °C to recrystallize, and finally cold rolling was performed. The copper foil thickness of Example 1 was 12 $\mu$m, and the copper foil thickness of Comparative Examples 1 and 2 was 18 $\mu$m. At this time, in the final cold rolling step, the oil film thickness equivalent in the final rolling pass was changed as shown in Table 1 to manufactured the copper foils of Examples and Comparative Examples.

Various evaluations were performed as follows for each sample of Examples and Comparative Examples manufactured as described above. The results are shown in Table 1.

(Measurement of developed interfacial area ratio)

Shape measurement was performed using a laser microscope VK-X1000 (controller unit) / 1050 (head unit) manufactured by Keyence. After that, using the analysis software for the laser microscope VK-X1000 (controller unit)/1050 (head unit) manufactured by Keyence, the developed interfacial area ratio sdr was measured. At this time, an area of 250 $\mu$m $\times$ 200 $\mu$m (specifically, 50,000 $\mu$m$^2$) was measured at arbitrary 10 points using a 50$\times$ objective lens of the laser microscope, and the developed interfacial area ratio sdr at each point was calculated. The arithmetic average value of the developed interfacial area ratio sdr obtained at the 10 points was taken as the value of the developed interfacial area ratio sdr. In addition, in order to eliminate the influence of the tilt and undulation of the surface of the object to be measured when the object was subjected to the shape measurement, during the analysis using the analysis software, surface tilt correction and undulation removal (cutoff wavelength 0.08 mm) were performed as surface shape correction for the measurement area, and then the developed interfacial area ratio sdr was calculated. In addition, the environmental temperature for measuring the developed interfacial area ratio sdr with the laser microscope was 20 to 25 °C. The main setting conditions for the laser microscope and the analysis software are as follows.

<Shape measurement conditions>

Objective lens: CF IC EPI Plan 50×

Optical zoom magnification: 1×

Average number of times: 1 time

Z-axis mode: recommended setting (R)

Shape measurement mode: simple measurement (scan mode: laser confocal)

<Analysis conditions>

Image processing: surface shape correction (flat tilt correction, undulation removal (cutoff wavelength 0.08 mm))

Surface roughness setting (filter setting)

Filter type: Gaussian

S-filter (low-pass filter): none

F-operation (shape correction): none

L-filter (high-pass filter): none

End effect correction: ON

(Measurement of high-frequency conductivity)

The samples of each Example and Comparative Example were processed into a disk shape of D = 15.0 mm by etching, and then annealed at 200 °C for 1 hour to simulate the temperature conditions during lamination of copper-clad laminates. In addition, the annealing was performed in an Ar atmosphere in order to prevent the formation of an oxide film on the sample surface. After that, the conductivity in the high frequency region was determined using the Balanced Circular Disc Resonator method (BCDR method). More specifically, conductivity was determined by the method described in IV-C in "Broadband Conductivity Measurement Technique at Millimeter-Wave Bands Using a Balanced-Type Circular Disk Resonator" (IEEE Transactions on Microwave Theory and Techniques, Volume: 69, Issue: 1, Jan 2021, pages: 861-873). For each sample, 10 measurements were carried out starting from mounting the sample to the measuring device. The average value of 10 measurements as the conductivity are shown in Table 1. The conductivity in Table 1 indicates that the higher the value is, the better the conductivity is. In addition, the frequency was measured at three points of 68 GHz, 81 GHz, and 107 GHz (all are rounded down after the decimal point).

Table 1

| | Copper ratio | Oil film thickness equivalent in final pass | sdr | Conductivity (e7S/m) | | |
|---|---|---|---|---|---|---|
| | | | | 68GHz | 81GHz | 107GHz |
| Example 1 | No less than 99.96% | 28000 | 0.0016 | 5.94 | 5.78 | 5.45 |
| Comparative Example 1 | No less than 99.96% | 58000 | 0.0262 | 5.65 | 5.31 | 5.09 |
| Comparative Example 2 | No less than 99.96% | 500000 | 0.0359 | 5.43 | 5.11 | 4.99 |

(Discussion)

In the Examples, since the developed interfacial area ratio sdr on the surface was 0.0030 or less, the decrease in electrical conductivity at high frequencies was suppressed. In particular, it is confirmed that the copper foils of the Examples can suppress the decrease in conductivity even at higher frequencies, so they have excellent conductivity as copper foils for high-frequency circuits. On the other hand, in the Comparative Example, since the oil film thickness equivalent in the final rolling pass in the final cold rolling was high, the developed interfacial area ratio exceeded 0.0030 and the electrical conductivity was lower than in the Example.

Further, the results of plotting sdr on the horizontal axis and conductivity on the vertical axis are shown in FIG. 1. In addition, the results of calculating an approximate straight line using the approximate straight line approximation function of Microsoft (registered trademark) Excel are shown in FIG. 1. The approximation formula of the straight line and the R-square value are also displayed. The closer the R-squared value is to 1, the better the fitted line represents the trend of the experimental data. Further, each approximate straight line is as follows in the case of 68 GHz, 81 GHz, and 107 GHz.

In the case of 68GHz

$$(\text{Conductivity}) = -14.2669 \times (\text{sdr}) + 5.9763$$

In the case of 81 GHz

$$(\text{Conductivity}) = -19.4499 \times (\text{sdr}) + 5.8130$$

In the case of 107GHz

$$(\text{Conductivity}) = -13.6501 \times (\text{sdr}) + 5.4665$$

Based on the approximate straight line in FIG. 1, the conductivity when sdr is 0.0030 and 0.0025 is estimated as shown in Table 2, and it can be understood that the conductivity is excellent when sdr is 0.0030 and 0.0025.

Table 2

| sdr | Conductivity (e7S/m) | | |
|---|---|---|---|
| | 68GHz | 81GHz | 107GHz |
| 0.0030 | 5.93 | 5.75 | 5.43 |
| 0.0025 | 5.94 | 5.76 | 5.43 |

**Claims**

1. A copper foil, wherein at least one surface of the copper foil has a developed interfacial area ratio (sdr) of 0.0030 or less.

2. The copper foil according to claim 1, wherein the at least one surface of the copper foil has the developed interfacial area ratio (sdr) of 0.0025 or less.

3. The copper foil according to claim 1 or 2, further comprising a surface treatment layer on the at least one surface.

4. The copper foil according to any one of claims 1 to 3, wherein the copper foil is a rolled copper foil.

5. A laminate, comprising the copper foil according to any one of claims 1 to 4; and a resin substrate.

6. A flexible printed wiring board provided with the laminate according to claim 5.

FIG. 1

Europäisches
Patentamt

European
Patent Office

Office européen
des brevets

# EUROPEAN SEARCH REPORT

Application Number

EP 23 19 3485

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/303405 A1 (FUKUCHI RYO [JP]) 19 October 2017 (2017-10-19) * paragraphs [0011], [0044], [0139], [0340], [0348]; claims 1-19 * | 1-6 | INV. H05K1/03 H05K3/02 B32B15/08 H05K1/09 B21B1/40 |
| X | US 2016/212836 A1 (ARAI HIDETA [JP] ET AL) 21 July 2016 (2016-07-21) * paragraphs [0051], [0165], [0170], [0267], [0335]; claims 1-34 * | 1-6 | |
| X | JP 2014 011451 A (JX NIPPON MINING & METALS CORP) 20 January 2014 (2014-01-20) * paragraphs [0002], [0011], [0022]; claims 1-7; table 1 * | 1-6 | |
| X | WO 2014/109396 A1 (JX NIPPON MINING & METALS CORP [JP]) 17 July 2014 (2014-07-17) * paragraph [0038]; claims 1-13 * | 1-6 | |
| X | US 2016/303829 A1 (ARAI HIDETA [JP] ET AL) 20 October 2016 (2016-10-20) * paragraphs [0184], [0232] - [0233], [0251], [0368]; claims 1-59; table 2 * | 1-6 | TECHNICAL FIELDS SEARCHED (IPC) H05K B21B B32B |
| X | JP 6 170516 B2 (JX NIPPON MINING & METALS CORP) 26 July 2017 (2017-07-26) * paragraphs [0001] - [0003], [0027]; claims 1-7 * | 1-6 | |
| A | US 2020/404784 A1 (SUNG YUN-HSING [TW] ET AL) 24 December 2020 (2020-12-24) * paragraphs [0003] - [0004], [0047]; claims 8-11 * | 1-6 | |
| A | WO 2021/157363 A1 (MITSUI MINING & SMELTING CO [JP]) 12 August 2021 (2021-08-12) * claims 1-11; table 1 * | 1-6 | |

The present search report has been drawn up for all claims

| Place of search | Date of completion of the search | Examiner |
|---|---|---|
| The Hague | 23 January 2024 | Pircher, Ernst |

EPO FORM 1503 03.82 (P04C01)

## ANNEX TO THE EUROPEAN SEARCH REPORT
## ON EUROPEAN PATENT APPLICATION NO.

EP 23 19 3485

This annex lists the patent family members relating to the patent documents cited in the above-mentioned European search report.
The members are as contained in the European Patent Office EDP file on
The European Patent Office is in no way liable for these particulars which are merely given for the purpose of information.

23-01-2024

| Patent document cited in search report | | | Publication date | Patent family member(s) | | | Publication date |
|---|---|---|---|---|---|---|---|
| US 2017303405 | A1 | | 19-10-2017 | CN | 107302825 | A | 27-10-2017 |
| | | | | EP | 3232747 | A1 | 18-10-2017 |
| | | | | JP | 2017193778 | A | 26-10-2017 |
| | | | | KR | 20170118623 | A | 25-10-2017 |
| | | | | PH | 12017000133 | A1 | 29-10-2018 |
| | | | | TW | 201805487 | A | 16-02-2018 |
| | | | | US | 2017303405 | A1 | 19-10-2017 |
| US 2016212836 | A1 | | 21-07-2016 | CN | 105612274 | A | 25-05-2016 |
| | | | | JP | 6196985 | B2 | 13-09-2017 |
| | | | | JP | 6498089 | B2 | 10-04-2019 |
| | | | | JP | 2016029215 | A | 03-03-2016 |
| | | | | JP | WO2015030209 | A1 | 02-03-2017 |
| | | | | KR | 20160052528 | A | 12-05-2016 |
| | | | | MY | 176312 | A | 28-07-2020 |
| | | | | PH | 12016500404 | A1 | 16-05-2016 |
| | | | | TW | 201518078 | A | 16-05-2015 |
| | | | | US | 2016212836 | A1 | 21-07-2016 |
| | | | | WO | 2015030209 | A1 | 05-03-2015 |
| JP 2014011451 | A | | 20-01-2014 | NONE | | | |
| WO 2014109396 | A1 | | 17-07-2014 | JP | 5576514 | B2 | 20-08-2014 |
| | | | | JP | 2014133936 | A | 24-07-2014 |
| | | | | TW | 201438890 | A | 16-10-2014 |
| | | | | WO | 2014109396 | A1 | 17-07-2014 |
| US 2016303829 | A1 | | 20-10-2016 | CN | 105814242 | A | 27-07-2016 |
| | | | | JP | 5819569 | B1 | 24-11-2015 |
| | | | | JP | WO2015087941 | A1 | 16-03-2017 |
| | | | | KR | 20160086377 | A | 19-07-2016 |
| | | | | MY | 183425 | A | 18-02-2021 |
| | | | | PH | 12016501106 | A1 | 11-07-2016 |
| | | | | TW | 201531172 | A | 01-08-2015 |
| | | | | US | 2016303829 | A1 | 20-10-2016 |
| | | | | WO | 2015087941 | A1 | 18-06-2015 |
| JP 6170516 | B2 | | 26-07-2017 | JP | 6170516 | B2 | 26-07-2017 |
| | | | | JP | 2016172275 | A | 29-09-2016 |
| US 2020404784 | A1 | | 24-12-2020 | CN | 112118671 | A | 22-12-2020 |
| | | | | CN | 113438806 | A | 24-09-2021 |
| | | | | JP | 7270579 | B2 | 10-05-2023 |
| | | | | JP | 7317924 | B2 | 31-07-2023 |
| | | | | JP | 2021001398 | A | 07-01-2021 |
| | | | | JP | 2022033061 | A | 25-02-2022 |

EPO FORM P0459

For more details about this annex : see Official Journal of the European Patent Office, No. 12/82

## ANNEX TO THE EUROPEAN SEARCH REPORT
## ON EUROPEAN PATENT APPLICATION NO.

EP 23 19 3485

23-01-2024

| Patent document cited in search report | Publication date | Patent family member(s) | | Publication date |
|---|---|---|---|---|
| | | TW | 202106930 A | 16-02-2021 |
| | | US | 2020404784 A1 | 24-12-2020 |
| | | US | 2021321514 A1 | 14-10-2021 |
| WO 2021157363 A1 | 12-08-2021 | CN | 115038818 A | 09-09-2022 |
| | | JP | 7177956 B2 | 24-11-2022 |
| | | JP | WO2021157363 A1 | 12-08-2021 |
| | | KR | 2022010619 9 A | 28-07-2022 |
| | | TW | 202134482 A | 16-09-2021 |
| | | WO | 2021157363 A1 | 12-08-2021 |

EPO FORM P0459

**REFERENCES CITED IN THE DESCRIPTION**

**Patent documents cited in the description**

- JP 4161304 B
- JP 4704025 B
- JP 2004244656 A
- JP 2017193778 A

**Non-patent literature cited in the description**

- Broadband Conductivity Measurement Technique at Millimeter-Wave Bands Using a Balanced-Type Circular Disk Resonator. *IEEE Transactions on Microwave Theory and Techniques,* January 2021, vol. 69 (1), 861-873